# EUROPÄISCHE PATENTSCHRIFT

(11) **EP 1 099 952 B1**
(45) Veröffentlichungstag und Bekanntmachung des Hinweises auf die Patenterteilung: **29.12.2004**
(21) Anmeldenummer: 00121371.9
(22) Anmeldetag: 11.10.2000
(51) Int. Cl.: G01R 31/3185, G06F 11/267

(54) **Schaltungszelle mit eingebauter Selbsttestfunktion und Verfahren zum Testen hierfür**
Circuit cell with built-in self test function and method to test it
Cellule de circuit avec fonction d'auto-test intégré et procédé pour essayer ledit circuit

(30) Priorität: 11.10.1999 DE 19948904
(43) Veröffentlichungstag der Anmeldung: 16.05.2001
(73) Patentinhaber: Infineon Technologies AG, 81669 München (DE)
(72) Erfinder: Schöber, Volker, 81543 München (DE)
(74) Vertreter: Reinhard - Skuhra - Weise & Partner

(56) Entgegenhaltungen:
- US-A- 5 173 904

## Beschreibung

Die Erfindung betrifft ein Verfahren zum Testen von Schaltungszellen, durch die eine Selbsttest-Schaltung modular aufgebaut werden kann, und Schaltungszellen mit eingebauter Selbsttestfunktion. Das Testverfahren kann bei modular aufgebauten Schaltungen eingesetzt werden.

Die US 5,442,643 beschreibt eine Leiterplatine mit mehreren darauf montierten integrierten Schaltkreisen und ein Verfahren zum Testen der auf der Leiterplatine montierten integrierten Schaltungen. Dabei besitzen die integrierten Schaltungen jeweils einen Hauptschaltungsbestandteil, Testschaltkreise, eine Latch-Schaltung und eine Systemschnittstelle, die den Dateneingang und den Datenausgang zu den Testschaltkreisen steuert. In dem Hauptschaltungsbestandteil werden verschiedene Funktionen beispielsweise Datenverarbeitungsvorgänge durchgeführt. Die Testschaltkreise sind schaltungstechnisch identisch zu den Hauptschaltungsbestandteil aufgebaut und mit diesem und der Systemschnittstelle jeweils über einen Bus verbunden.

Die US 5173904 beschreibt eine Schaltung die modular aufgebart werden kann und die Schaltungszellen eingebarte vom Systembus unabhängige Testanschlüsse aufweisen. Das Testen der Schaltung erfolgt mit Abtastprüfung wobei der Abtastpfad der Module einzeln ein- oder ausgeschaltet werden kann.

In dem Aufsatz Design for Testability - A Survey" in Proceedings of the IEEE, Band 72, Nr. 1, Januar 1983 Seiten 98-112 wird die Struktur eines BILBO-Registers und dessen verschiedene Betriebsarten zur Testmustergenerierung, Signaturanalyse bzw. Testmusterauswertung sowie der Betrieb des BILBO-Registers als Scanregister beschrieben. Kombiantorische Netzwerke werden mittels umgebender BILBO-Register getestet, indem BILBO-Register vor dem zu testenden Netzwerk als Testmustergenerator und das nachfolgende BILBO-Register als Signaturanalyse-Register betrieben wird.

Integrierte Schaltungen werden nach der Herstellung einem Testverfahren zum Testen des logischen und dynamischen Verhaltens unterzogen, um einerseits fehlerhafte Schaltungen zu erkennen und andererseits anhand der Testergebnisse die Leistungsfähigkeit der integrierten Schaltungen zu prüfen. Die integrierten Schaltungen bestehen aus einer Vielzahl von logischen Bauelementen, die ihrerseits aus Schaltelementen bzw. Transistoren bestehen. Hochkomplex integrierte Schaltungen weisen bis zu 100.000.000 Schaltelemente bzw. Transistoren auf. Bei bekannten Testverfahren werden Stimulationstestmuster durch einen Testautomaten an die integrierte Schaltung angelegt und Antworttestmuster an den Ausgängen der integrierten Schaltung durch den Testautomaten ausgelesen und mit einer Soll-Antwort verglichen. Das Testantwortmuster, das von der zu untersuchenden Schaltung (DUT: Device under Test) abgegeben wird, muß mit der Soll-Testantwort übereinstimmen, damit die integrierte Schaltung als fehlerfrei erkannt wird.

Integrierte Schaltungen werden zunehmend mit BIST-Strukturen (BIST: Built-in Self Test), Strukturen mit eingebautem Selbsttest, aufgebaut, d.h. in die integrierte Schaltung wird zusätzlich eine Logik implementiert, die Testmustergeneratoren und Testdaten-Auswertemodule umfaßt. Der Testautomat liefert dabei lediglich ein Taktsignal für die zu untersuchende integrierte Schaltung und bestimmt aufgrund der von den Testdaten-Auswertemodulen ausgelesenen Daten, ob die integrierte Schaltung fehlerhaft ist oder nicht.

Integriert man in die Schaltung eine Selbsttestfunktion, so ersetzt man die Speichereinheit durch eine besondere Speichereinheit, die in der Lage ist, Testmuster zu generieren bzw. Testmuster zu komprimieren.

Die Speichereinheit der Schaltungszelle besteht dabei meist aus einem BILBO-Register (BILBO: Built-in Logik Block Observation). Ein BILBO-Register ist ein Register, das selbständig Testmuster generieren kann und/oder Testmusterdaten komprimieren kann. Ein BILBO-Register weist im allgemeinen vier Betriebszustände auf, nämlich einen normalen Betriebszustand als Register, einen Betriebszustand zur Testmustergenerierung und Testmustersendung, einen Betriebszustand zum Testdatenempfang und zur Testdatenkomprimierung sowie einen Betriebszustand als serielles Schieberegister für die Initialisierung und das Testdatenauslesen bzw. -einlesen.

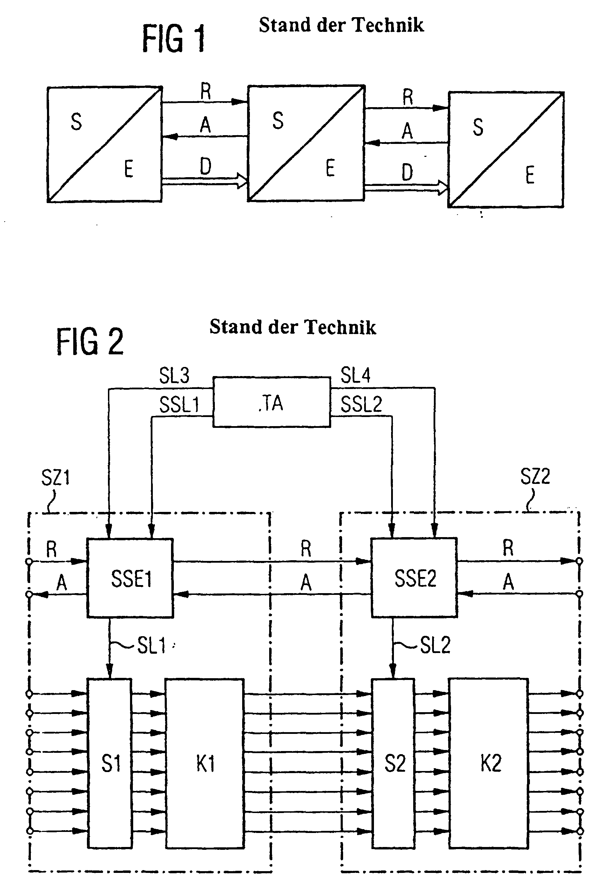

Fig. 2 zeigt zwei miteinander verbundene Schaltungszellen im Detail während eines Testlaufs.

Die Schaltung SZ1 enthält eine kombinatorische Schaltung K1 zur Datenverarbeitung, eine Speichereinheit S1 zum Speichern von Daten, beispielsweise ein BILBO-Register, und eine Speichersteuereinheit SSE1 zur Steuerung der Speichereinheit S1. Die zweite Speicherzelle SZ2 enthält eine kombinatorische Schaltung K2 zur Datenverarbeitung, eine Speichereinheit S2 zum Speichern von Daten, beispielsweise ein BILBO-Register, und eine Speichersteuereinheit SSE2 zur Steuerung der Speichereinheit S2. Die Speichersteuereinheiten SSE1 und SSE2 sind jeweils über mehrere Steuerleitungen SL1 bzw. SL2 mit den Speichereinheiten S1, S2 verbunden. Die Steuerleitungen SL1, SL2 bestehen jeweils im wesentlichen aus drei Steuerleitungen. Die erste Steuerleitung dient zur Abgabe eines Testmuster-Generierungsbefehls von der Speichersteuereinheit (SSE) zu der zugehörigen Speichereinheit S. Die zweite Steuerleitung dient zur Abgabe eines Testmuster-Komprimierungsbefehls von der Speichersteuereinheit (SSE) zu der Speichereinheit S. Die dritte Steuerleitung liefert ein Sychronisiersignal von der Speichersteuereinheit (SSE) zu der Speichereinheit S.

Im Testbetrieb steuert ein Testautomat TA über Steuerleitungen SL3, SL4 die lokalen Speichersteuereinheiten SSE1, SSE2 der Schaltungszellen und gibt über Synchronisiersignalleitungen SSL1, SSL2 ein Synchronisiersignal S an die Speichersteuereinheiten SSE1 und SSE2 ab. Das Synchronisiersignal S wird in den Speichersteuereinheiten SSE1, SSE2 an die zugehörige Speichereinheit S1, S2 zur Synchronisierung durchgeschaltet.

Ein Nachteil bei einem derartigen Testverfahren besteht darin, daß die Vielzahl von Speichersteuereinheiten SSE über eine Vielzahl von Synchronisiersignalleitungen SSL an den Testautomaten TA angeschlossen sein müssen. Das Vorsehen eines derartigen Taktsystems, das auf der zu testenden integrierten Schaltung zum Testen vorgesehen sein muß, ist aufgrund der Signallaufzeitunterschiede nur mit sehr hohem Aufwand realisierbar. Durch Vorsehen von Inverterketten mit unterschiedlichen Laufzeiten können die Signalsynchronisierleitungen SSL derart ausgebildet werden, daß die Laufzeiten der Signale zu den unterschiedlichen Speichersteuereinheiten SSE ausgeglichen werden. Die zusätzlichen Inverterketten bilden ihrerseits zusätzliche Fehlerquellen und führen zu einem erheblich höheren Stromverbrauch der integrierten Schaltung.

Synchrone Schaltungen werden durch ein zentral erzeugtes Taktsignal synchronisiert. Die Verteilung eines synchronen Taktsignals auf einer integrierten Schaltung ist aufgrund der Signallaufzeiten nur sehr aufwendig zu realisieren. Dies geschieht beim Stand der Technik beispielsweise durch Inverterketten mit unterschiedlichen Laufzeiten und Treiberleitungen. Daher werden zunehmend asynchrone Schaltungen eingesetzt. Diese können in einem modularisierten Schaltungskonzept realisiert werden. Auf der untersten Ebene besteht die modular aufgebaute asynchrone Schaltung aus Schaltungszellen, die jeweils eine kombinatorische Schaltung zur Datenverarbeitung, eine Speichereinheit und eine Speichersteuereinheit aufweisen. Die Speichersteuereinheiten der Schaltungszellen sind über Kommunikationsleitungen mit den Speichersteuereinheiten weiterer Schaltungszellen verbunden und tauschen Aufforderungssignale (Request) und Empfangsbestätigungssignale (Acknowledge) aus. Jede Schaltungszelle kann als Sendeschaltungszelle auf der Datenausgangsseite oder als Empfangsschaltungszelle auf der Dateneingangsseite betrieben werden.

Fig. 1 zeigt ein Blockschaltbild einer asynchronen Schaltung mit drei Schaltungszellen, die jeweils als Sende- oder Empfangsschaltungszelle schaltbar sind. Die Schaltungszellen sind über Datensende-Aufforderungsleitungen (R: Request) und Datenempfangs-Bestätigungsleitungen (A: Acknowledge) miteinander verbunden. Ferner werden Daten zur weiteren Datenverarbeitung von einer Sendeschaltungszelle über Datenleitungen D an eine Empfangs-Standardzelle übertragen.

Es ist daher die Aufgabe der vorliegenden Erfindung, ein Testverfahren von Schaltungszellen mit eingebauter Selbsttestfunktion zu schaffen, bei dem das Testen mit geringfügigem schaltungstechnischen Aufwand erfolgt, wobei insbesondere kein globales Taktsystem zur Übertragung von Synchronisiersignalen zu den Schaltungszellen mehr erforderlich ist.

Diese Aufgabe wird erfindungsgemäß durch ein Verfahren zum Testen von Schaltungszellen mit den in Patentanspruch 1 angegebenen Merkmalen sowie durch Schaltungszellen mit eingebauter Selbsttestfunktion mit den in Patentanspruch 6 angegebenen Merkmalen gelöst.

Vorteilhafte Ausgestaltungen der Erfindung sind in den Unteransprüchen angegeben.

Die Erfindung schafft ein Verfahren zum Testen von Schaltungszellen, die jeweils eine kombinatorische Schaltung zur Datenverarbeitung, eine Speichereinheit und eine Speichersteuereinheit enthalten, wobei die Synchronisation zwischen den Schaltungszellen sowie die Testmustergenerierung und/oder Testmusterauswertung dezentral durch die in den Schaltungszellen enthaltenen Speichersteuerungseinheiten erfolgt, wobei das Verfahren die folgenden Schritte aufweist, nämlich: Initialisieren der Schaltungszelle als Testmuster-Sendeschaltungszelle und Testmuster-Empfangsschaltungszelle, Senden eines Befehlssignals von der Speichersteuereinheit der Testmuster-Sendeschaltungszelle zu der zugehörigen Speichereinheit zum Generieren eines Testmuster,
Senden des generierten Testmusters von der Speichereinheit der Testmuster-Sendeschaltungszelle an die kombinatorische Schaltung zur Datenverarbeitung,
Senden eines Aufforderungssignals von der Speichersteuereinheit der Testmuster-Sendeschaltungszelle an die Speichersteuereinheit der Testmuster-Empfangsschaltungszelle,
Senden eines Befehls von der Speichersteuereinheit der Testmuster-Empfangsschaltungszelle an die zugehörige Speichereinheit zur Testmusterkomprimierung,
Senden eines Bestätigungssignals von der Speichersteuereinheit der Testmuster-Empfangsschaltungszelle an die Speichersteuereinheit der Testmuster-Sendeschaltungszelle,
Schalten der Speichereinheit der Testmuster-Empfangsschaltungszelle in den Testdaten-Auswertebetrieb durch die Speichersteuereinheit der Testmuster-Empfangsschaltungszelle,
Senden eines Aufforderungssignals an den Testautomaten zum Auslesen der Testdaten durch die Speichersteuereinheit der Testmuster-Empfangsschaltungszelle,
Auslesen der Testdaten durch den Testautomaten aus der Speichereinheit der Testmuster-Empfangsschaltungszelle.

Die ausgelesenen Testdaten werden vorzugsweise mit einer Soll-Antwort verglichen.

Bei einer bevorzugten Weiterbildung des erfindungsgemäßen Verfahrens wird die Speichereinheit einer Standardzelle durch ein Synchronisiersignal synchronisiert, das durch die zugehörige Speichersteuereinheit in Abhängigkeit von Kommunikationssignalen erzeugt wird, welche die Speichersteuereinheit mit Speichersteuereinheiten von weiteren Standardzellen austauscht.

Dies bietet den besonderen Vorteil, daß bei dem erfindungsgmäßen Verfahren das Funktionieren des Kommunikationssignalaustausches mitgetestet wird.

Bei einer weiteren bevorzugten Ausbildung des erfindungsgemäßen Verfahrens tauschen die Speichersteuereinheiten der verschiedenen Standardzellen Datensende-Aufforderungssignale und Datenempfangs-Bestätigungssignale untereinander als Kommunikationssignale aus.

Die Erfindung schafft ferner eine Schaltungszelle einer integrierten Schaltung mit eingebauter Selbsttestfunktion für eine modular aufgebaute Schaltung mit: einer Speichereinheit zum Speichern von Daten, die von einer kombinatorischen Schaltung zur Datenverarbeitung gefolgt wird, einer Speichersteuereinheit zur Steuerung der Speichereinheit, wobei die Speichersteuereinheit im Testbetrieb derart konfigurierbar ist, daß sie in einem Sendebetrieb die Speichereinheit als Testmustergenerator und in einem Empfangsbetrieb als Testmuster-Komprimierungseinrichtung einstellt, und die Speichersteuereinheit ein Synchronisiersignal zur Synchronisation der Speichereinheit in Abhängigkeit von Kommunikationssignalen erzeugt, die die Speichersteuereinheit mit Speichersteuereinheiten von weiteren Schaltungszellen der integrierten Schaltung austauscht.

Die Speichersteuereinheit ist vorzugsweise über Kommunikationsleitungspaare an Speichersteuereinheiten von weiteren Schaltungszellen anschließbar, wobei jedes Kommunikationsleitungspaar eine Datensende-Aufforderungsleitung und eine Datenempfangs-Bestätigungsleitung aufweist.

Bei einer bevorzugten Weiterbildung ist die Speichersteuereinheit über ein Kommunikationsleitungspaar an einen Testautomaten anschließbar, wobei die Speichersteuereinheit über eine Initialisierungsleitung durch den Testautomaten initialisierbar ist und die Speichersteuereinheit über eine Zustandsmeldeleitung interne Zustandsdaten an den Testautomaten sendet.

Die Speichereinheit ist vorzugsweise ein BILBO-Register.

Im weiteren werden bevorzugte Ausführungsformen des erfindungsgemäßen Verfahrens zum Testen von Schaltungszellen sowie der erfindungsgemäßen Schaltungszelle mit eingebauter Selbsttestfunktion unter Bezugnahme auf die beigefügten Zeichnungen zur Erläuterung erfindungswesentlicher Merkmale beschrieben.

Es zeigen:
Fig. 1 eine modular aufgebaute Schaltung mit mehreren Schaltungszellen nach dem Stand der Technik;
Fig. 2 zwei Schaltungszellen, die durch ein herkömmliches Testverfahren nach dem Stand der Technik getestet werden;
Fig. 3 eine Schaltungszelle mit eingebauter Selbsttestfunktion gemäß der Erfindung;
Fig. 4 ein Ablaufdiagramm des erfindungsgemäßen Verfahrens zum Testen von Schaltungszellen gemäß der Erfindung.

Die Schaltungszelle 1 weist eine Speichereinheit 2 zum Speichern von Daten, eine kombinatorische Schaltung 3 zur Datenverarbeitung und eine Speichersteuereinheit 4 zur Steuerung der Speichereinheit 2 auf.

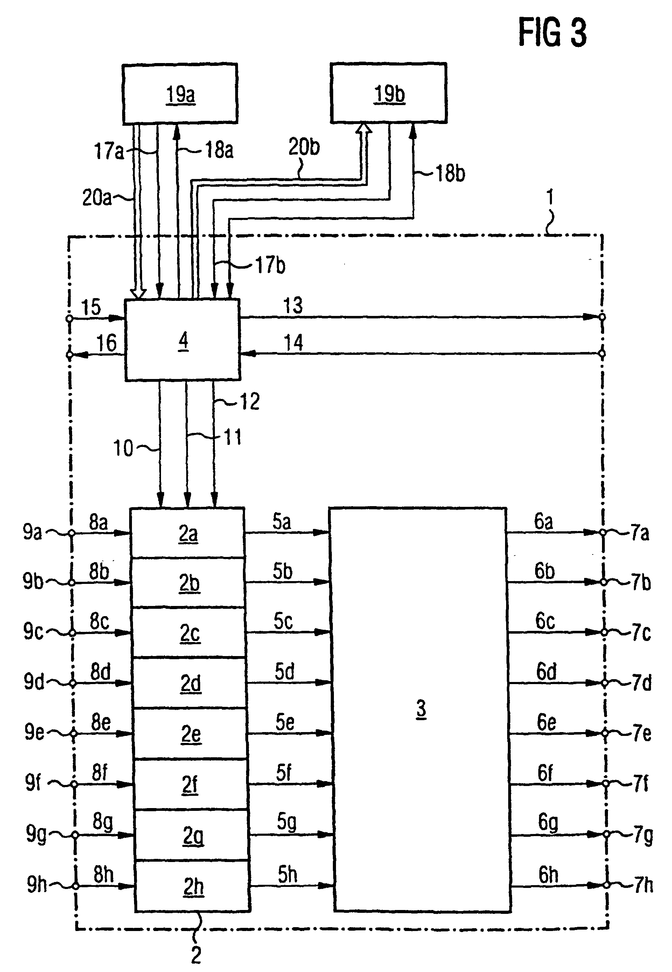

Die Speichereinheit 2 enthält mehrere Speicherzellen 2a, 2b, 2c, 2d, 2e, 2f, 2g, 2h zum Zwischenspeichern von Daten. Die Speichereinheit 2 ist vorzugsweise ein BILBO-Register, das in verschiedenen Betriebsarten betreibbar ist. Es weist vorzugsweise vier Betriebsarten auf, wobei das BILBO-Register im Normalbetrieb als Register bzw. Zwischenspeicher funktioniert, in einer zweiten Betriebsart Testmuster generiert und sendet, in einer dritten Betriebsart Testmusterdaten empfängt und komprimiert und in einer vierten Betriebsart als serielles Schieberegister durch Dateneinlesen initialisiert wird oder Daten zum Testdatenauslesen abgibt. Die Speicherzellen 2a-2h sind jeweils über interne Datenleitungen 5a-5h mit der kombinatorischen Schaltung 3 verbunden. Die kombinatorische Schaltung 3 führt eine Datenverarbeitung der an den Leitungen 5a-5h anliegenden Daten durch. Die kombinatorische Schaltung 3 ist vorzugsweise eine Logikschaltung, die aus einer Vielzahl von Gattern besteht. Die kombinatorische Schaltung 3 verarbeitet die Daten und gibt Ausgangsdaten über Leitungen 6a-6h an Ausgangsdatenanschlüsse 7a-7h ab. Die Speichereinheit 2 ist über interne Datenleitungen 8a-8h mit Dateneingangsanschlüssen 9a-9h verbunden. Bei der in Fig. 3 gezeigten Ausführungsform entspricht die Anzahl der Ausgangsdatenanschlüsse 7a-7h einer erfindungsgemäßen Schaltungszelle 1 der Anzahl von Eingangsanschlüssen 9a-9h der erfindungsgemäßen Schaltungszelle 1. Dies erleichtert einen systolischen Aufbau mit weiteren Schaltungszellen 1.

Die Schaltungszellen 1 können in einer Gesamtschaltung derart verteilt liegen, daß zwischen einer Sende-Schaltungszelle und einer Empfangsschaltungszelle eine beliebig hohe Anzahl an Datenregistern vorgesehen ist.

Die Speichereinheit 2 wird über Steuerleitungen 10, 11 durch die Speichersteuerungseinheit 4 gesteuert und erhält im Testbetrieb über eine Synchronisierleitung 12 ein Taktsignal. Über die Steuerleitungen 10, 11 wird die Betriebsart der Speichereinheit 2 eingestellt. Über die Steuerleitung 10 wird ein Befehl zur Testmustergenerierung TMG und über die Steuerleitung 11 ein Befehl zur Testmusterkomprimierung TMK gesendet.

Bei einer bevorzugten Ausführungsform werden die vier Betriebsarten des BILBO-Registers 2 entsprechend folgender Tabelle eingestellt.

| Betriebsart | TMK | TMG |
|---|---|---|
| Normalbetrieb | 0 | 0 |
| Testmusterkomprimierung | 1 | 0 |
| Testmustergenerierung (Schieberegisterbetrieb) | 0 | 1 |
| Initialisierung | 1 | 1 |

Die Speichersteuereinheit 4 sendet über die Synchronisierleitung 12 ein Synchronisiersignal S zur Synchronisation der Speichereinheit 2 in Abhängigkeit von Kommunikationssignalen, die die Speichersteuereinheit 4 mit Speichersteuereinheiten weiterer Schaltungszellen austauscht. Die Speichersteuereinheit ist über Kommunikationsleitungspaare 13, 14; 15, 16 an Speichersteuereinheiten von anderen Schaltungszellen anschließbar. Jedes Kommunikationsleitungspaar weist eine Datensende-Aufforderungsleitung 13 zum Senden eines Aufforderungssignals bzw. Request-Signals und eine Datenempfangs-

Bestätigungsleitung 14 zum Empfang eines Bestätigungssignals bzw. Acknowledgement-Signals. Die Speichersteuereinheit 4 erhält, wenn die Schaltungszelle 1 als Testmuster-Empfangsschaltungszelle konfiguriert ist, über die Datensende-Aufforderungsleitung 15 ein Aufforderungssignal zur Datenübertragung von einer Testmuster-Sendeschaltungszelle und sendet über die Datenempfangs-Bestätigungsleitung 16 ein Bestätigungssignal an diese Testmuster-Sendeschaltungszelle nach erfolgter Datenübertragung zurück.

Ist die Schaltungszelle 1 als Testmuster-Sendeschaltungszelle konfiguriert, sendet sie über die Datensende-Aufforderungsleitung 13 ein Aufforderungssignal an eine nachgeschaltete Testmuster-Empfangsschaltungszelle und erhält über die Datenempfangs-Bestätigungsleitung 14 von dieser Testmuster-Empfangsschaltungszelle ein Datenempfangs-Bestätigungssignal bzw. Acknowledgement-Signal.

Im Testbetrieb ist die Speichersteuereinheit 4 über ein Kommunikationsleitungspaare 17a, 18a; 17b, 18b an externe Testautomaten 19a, 19b anschließbar. Dabei wird die Speichersteuereinheit 4 über eine Initialisierungsleitung 17a durch den Testautomaten 19a initialisiert und sendet während des Testvorgangs über eine Zustandsmeldeleitung 18a interne Zustandsdaten an den Testautomaten 19a. Der Testautomat 19a weist ein Initialisierungsmodul auf. Der Testautomat 19b wertet als Auswerteeinheit die Testergebnisse aus. Die Testautomaten 19a, 19b sind jeweils über Datenleitungen 20a, 20b beim Testbetrieb an die Speichersteuereinheit 4 angeschlossen.

Das über die Synchronisierleitung 12 an die Speichereinheit 2 zur Synchronisation der Speichereinheit während des Testvorgangs gesendete Synchronisiersignal S wird durch die Speichersteuereinheit 4 in Abhängigkeit von den über die Kommunikationssignalleitungen 13, 14 bzw. 15, 16 von weiteren Schaltungszellen ausgetauschten Kommunikationssignalen gebildet. Das Synchronisiersignal S wird nicht in den Testautomaten 19a, 19b erzeugt, sondern selbständig dezentral in der Speichersteuerungseinheit 4 der Schaltungszelle 1.

Es ist daher nicht nötig, eine Taktleitung auf der integrierten Schaltung zur Zuführung eines Taktsignals von den Testautomaten 19 zu der Speichersteuereinheit 4 einer Schaltungszelle 1 vorzusehen. Hierdurch kann der schaltungstechnische Aufwand der integrierten Schaltung sowie deren Stromverbrauch erheblich vermindert werden. Darüber hinaus wird bei dem Testvorgang die Funktionalität der Speichersteuereinheiten 4 der Schaltungszellen 1 mitgetestet. Bei dem Testvorgang wird zudem vorteilhafterweise geprüft, ob die Kommunikation zwischen den Speichersteuereinheiten 4 der verschiedenen Schaltungszellen 1 über die Kommunikationsleitungen 13, 14 bzw. 15, 16 funktioniert. Ferner erlauben die erfindungsgemäßen Schaltungszellen 1 vorteilhafterweise, daß bei dem Testvorgang die Arbeitsgeschwindigkeit der Speichersteuerblöcke 4 mitgetestet wird. Ein weiterer Vorteil besteht darin, daß die Funktionsfähigkeit der Speichersteuereinheit 4 und der kombinatorischen Schaltungen 3 innerhalb der Schaltungszellen 1 bzw. des Steuer- und Datenpfades zusammen getestet wird. Bisher wurden die Speichersteuerblöcke 4 beim Stand der Technik durch separate Testverfahren getestet.

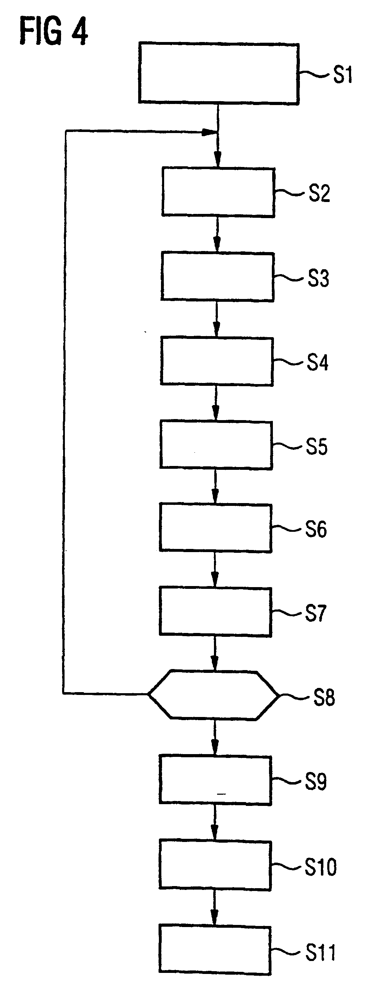

Fig. 4 zeigt ein Ablaufdiagramm des erfindungsgemäßen Verfahrens zum Testen von Schaltungszellen mit integrierter Selbsttestfunktion.

In Schritt S1 initialisiert der Testautomat 19a eine erste Standardzelle 1 als Testmuster-Senderschaltungszelle und eine zweite Standardzelle 1 als Testmuster-Empfangsschaltungszelle. Gleichzeitig werden die zugehörigen Speichersteuereinheiten 4 initialisiert. Ferner wird in Schritt S1 die Anzahl der Testmusterschleifen N festgelegt. Die Initialisierung erfolgt über einen seriellen Prüfpfad oder das Rücksetzen der Register.

In Schritt S2 gibt die lokale Speichersteuereinheit 4 der Senderschaltungszelle der zugehörigen Speichereinheit 2 über die Steuerleitungen einen Befehl, ein Testmuster zu generieren.

In Schritt S3 legt die Speichereinheit 2 das generierte Testmuster über die Leitungen 5a-5h an die kombinatorische Schaltung 3 zur Datenverarbeitung an. Die kombinatorische Schaltung 3 führt die Testdatenverarbeitung durch und gibt über die Ausgangsleitungen 6a-6h ein verarbeitetes Testdatenmuster an die nachgeschaltete Empfangsschaltungszelle 1 ab.

In Schritt S4 sendet die Speichersteuereinheit 4 der Senderschaltungszelle ein Aufforderungssignal über die Kommunikationsleitung 13 an eine Speichersteuereinheit 4 der nachgeschalteten Empfangsschaltungszelle.

Nachdem die Speichersteuereinheit 4 das Aufforderungssignal bzw. Request-Signal von der Senderschaltungszelle empfangen hat, gibt sie in Schritt S5 der zugehörigen Speichereinheit 2 über die Steuerleitungen einen Befehl zur Testmusterkomprimierung.

In Schritt S6 sendet die Speichersteuereinheit der Empfangsschaltungszelle ein Bestätigungssignal bzw. Acknowledgement-Signal an die Senderschaltungszelle.

In Schritt S7 wird ein Zähler n erhöht, bzw. geprüft, ob das Ende der Testmustergenerierung erreicht ist.

In Schritt S8 wird geprüft, ob die Anzahl N der eingestellzen Testmusterschleifen erreicht ist. Falls in Schritt S8 festestellt wird, daß noch weitere Testschleifen zu durchlaufen sind, kehrt der Ablauf zu Schritt S2 zurück.

Falls die Anzahl der Testschleifen den ursprünglich eingestellten Wert erreicht hat, geht der Ablauf zu Schritt S9 über, bei dem die Speichersteuereinheit 4 der Empfangsschaltungszelle die zugehörige Speichereinheit 2 in den Testdaten-Auswertebetrieb schaltet.

Danach sendet die Speichersteuereinheit 4 der Empfangsschaltungszelle im Schritt S10 ein Aufforderungssignal an den Testautomaten 19b zum Auslesen der an der zugehörigen Speichereinheit 2 komprimierten Testdaten. In Schritt S11 sendet der Testautomat 19b eine Bestätigung bzw. Quittungssignal, daß die Testdaten aus der Speichereinheit 2 der Empfangsschaltungszelle empfangen wurden.

Die ausgelesenen Testdaten werden daraufhin mit einer Testdaten-Sollantwort verglichen und festgestellt, ob die Schaltungszellen der zu prüfenden integrierten Schaltung fehlerhaft sind oder nicht.

Die Synchronisation zwischen der Testmuster-Sendeschaltungszelle und der Testmuster-Empfangsschaltungszelle, die Testmustergenerierung und/oder Testmusterauswertung erfolgt bei dem in Fig. 4 gezeigten erfindungsgemäßen Verfahren dezentral durch die in den Schaltungszellen enthaltenen Speichersteuereinheiten 4. Der Testautomat 19a liefert lediglich Initialisierungsbefehle und keine Synchronisiersignale an die Speichersteuerungseinheiten 4. Inverterketten zum Ausgleich von Laufzeitunterschieden zur gleichmäßigen Synchronisation der auf der integrierten Schaltung vorhandenen Schaltungszellen sind bei dem erfindungsgemäßen Testverfahren nicht notwendig. Hierdurch wird das globale Synchronisationsnetzwerk der zu testenden integrierten Schaltung nicht mehr benötigt und deren Stromverbrauch erheblich vermindert. Darüber hinaus können die Stromversorgungsleitungen und Masseleitungen der integrierten Schaltung erheblich reduziert werden, da die verschiedenen Schaltungseinheiten der Schaltungszellen zu unterschiedlichen Zeitpunkten schalten. Auch hierdurch wird die Komplexität der integrierten Schaltung insgesamt erheblich vermindert. Das erfindungsgemäße Testverfahren ermöglicht es zudem, die Leistungsfähigkeit bzw. Performance der integrierten Schaltung zuverlässig zu bestimmen.

Das erfindungsgemäße Testverfahren paßt sich bei Kühlung der Schaltung an die Geschwindigkeitssteigerungen an. Die Testmodule mit lokaler Speichersteuereinheit 4 können auch mittels Testverfahren getestet werden, die über eine globale Steuerung synchronisiert werden. Dabei erzeugt ein Testautomat die nötige Testantwort, die die Test-Sendeschaltungszelle von der Test-Empfangschaltungszelle erwartet.

### Bezugszeichenliste

- 1: Schaltungszelle
- 2: Speichereinheit
- 3: kombinatorische Schaltung
- 4: Speichersteuerungseinheit
- 5: Datenleitungen
- 6: Datenleitungen
- 7: Datenausgangsanschlüsse
- 8: Datenleitungen
- 9: Dateneingangsanschlüsse
- 10: Steuerleitung
- 11: Steuerleitung
- 12: Synchronisierleitung
- 13: Anforderungsleitung
- 14: Bestätigungsleitung
- 15: Anforderungsleitung
- 16: Bestätigungsleitung
- 17a, 18b: Initialisierungsleitungen
- 18a, 17b: Zustandsmeldeleitungen
- 19a, 19b: Testautomaten
- 20a, 20b: Datenleitungen

## Patentansprüche

1. Verfahren zum Testen von Schaltungszellen(1) einer integrierten Schaltung, wobei eine Schaltungszelle (1) jeweils eine kombinatorische Schaltung (3) zur Datenverarbeitung, eine Speichereinheit (2) und eine Speichersteuereinheit (4) enthält, wobei die Synchronisation zwischen den Schaltungszellen (1), die Testmustergenerierung und die Testmusterauswertung dezentral durch die in den Schaltungszellen (1) enthaltenen Speichersteuerungseinheiten (4) erfolgt und das Verfahren die folgenden Schritte aufweist:
(a) Initialisieren (S1) einer Schaltungszelle als Testmuster-Sendeschaltungszelle und einer Schaltungszelle als Testmuster-Empfangsschaltungszelle;
(b) Senden (S2) eines Befehlssignals von der Speichersteuereinheit (4) der Testmuster-Sendeschaltungszelle an die zugehörige Speichereinheit (2) zum Generieren eines Testmusters;
(c) Anlegen (S3) des generierten Testmusters an die kombinatorische Schaltung (3) zur Datenverarbeitung durch die Speichereinheit der Testmuster-Sendeschaltungszelle;
(d) Senden (S4) eines Anforderungssignals (R) durch die Speichersteuereinheit (4) der Testmuster-Sendeschaltungszelle an die Speichersteuereinheit (4) der Testmuster-Empfangsschaltungszelle;
(e) Senden (S5) eines Befehls zur Testmusterkomprimierung an die Speichereinheit (2) der Testmuster-Empfangsschaltungszelle durch die Speichersteuereinheit (4) der Empfangsschaltungszelle;
(f) Senden (S6)eines Bestätigungssignals (A) von der Speichersteuereinheit (4) der Testmuster-Empfangsschaltungszelle an die Speichersteuereinheit der Testmuster-Sendeschaltungszelle;
(g) Schalten der Speichereinheit (2) der Testmuster-Empfangsschaltungszelle in einen Testdaten-Auswertungsbetrieb durch die Speichersteuereinheit (4) der Testmuster-Empfangsschaltungszelle;
(h) Senden (S10) eines Aufforderungssignals an den Testautomaten (19) zum Auslesen der komprimierten Testdaten durch die Speichersteuereinheit (4) der Testmuster-Empfangsschaltungszelle;
(i) Auslesen der Testdaten aus der Speichereinheit (2) der Testmuster-Empfangsschaltungszelle durch den Testautomaten (19).

2. Verfahren nach Anspruch 1,
**dadurch gekennzeichnet,**
**daß** die ausgelesenen Testdaten mit einer Testdaten-Sollantwort verglichen werden.

3. Verfahren nach einem der vorangehenden Ansprüche,
**dadurch gekennzeichnet,**
**daß** die Speichereinheit (2) der Schaltungszelle durch ein Synchronisiersignal synchronisiert wird, das durch die zugehörige Speichersteuereinheit (4) in Abhängigkeit von Kommunikationssignalen erzeugt wird, welche die Speichersteuereinheit (4) mit Speichersteuereinheiten von weiteren Standardzellen austauscht.

4. Verfahren nach einem der vorangehenden Ansprüche,
**dadurch gekennzeichnet,**
**daß** die Speichersteuereinheiten (4) der verschiedenen Schaltungszellen Datensende-Aufforderungssignale und Datenempfangs-Bestätigungssignale untereinander als Kommunikationssignale austauschen.

5. Verfahren nach einem der vorangehenden Ansprüche,
**dadurch gekennzeichnet,**
**daß** die dezentrale Synchronisation über Handshake-Signale erfolgt.

6. Schaltungszelle in einer integrierten Schaltung mit eingebauter Selbsttestfunktion für eine modular aufgebaute Schaltung mit:
(a) einer Speichereinheit (2) zum Speichern von Daten;
(b) einer kombinatorischen Schaltung (3) zur Datenverarbeitung;
(c) einer Speichersteuereinheit (4) zur Steuerung der Speichereinheit (2)
**dadurch gekennzeichnet, daß**
die Speichersteuereinheit (4) derart konfigurierbar ist, daß sie in einem Sendebetrieb die Speichereinheit (2) als Testmustergenerator und in einem Empfangsbetrieb als Testmuster-Komprimierungseinrichtung einstellt, und die Speichersteuereinheit (4) ein Synchronisiersignal zur Synchronisation der Speichereinheit (2) in Abhängigkeit von Kommunikationssignalen erzeugt, die die Speichersteuereinheit (4) mit Speichersteuereinheiten von weiteren Schaltungszellen der integrierten Schaltung austauscht.

7. Schaltungszelle nach Anspruch 6,
**dadurch gekennzeichnet,**
**daß** die Speichersteuereinheit (4) über mindestens zwei Kommunikationsleitungspaare (13, 14; 15, 16) an Speichersteuereinheiten von weiteren Schaltungszellen (1) anschließbar ist, wobei jedes Kommunikationsleitungspaar eine Datensende-Aufforderungsleitung (13, 15) und eine Datenempfangs-Bestätigungsleitung (14, 16) aufweist.

8. Schaltungszelle nach einem der vorangehenden Ansprüche,
**dadurch gekennzeichnet,**
**daß** die Speichersteuereinheit (4) über ein Kommunikationsleitungspaar (17, 18) an mindestens einen Testautomaten (19) anschließbar ist, wobei die Speichersteuereinheit (4) über eine Initialisierungsleitung (17) durch den Testautomaten (19) mit Hilfe von dezentralen Synchronisierungssignalen initialisierbar ist und die Speichersteuereinheit (4) über eine Zustandsmeldeleitung (18) interne Zustandsdaten an den Testautomaten (19) sendet.

9. Schaltungszelle nach einem der vorangehenden Ansprüche,
**dadurch gekennzeichnet,**
**daß** die Speichereinheit (2) ein Register ist, das zwischen den verschiedenen Betriebsarten schaltbar ist.

10. Schaltungszelle nach Anspruch 9,
**dadurch gekennzeichnet,**
**daß** das Register zwischen einem normalen Datenspeicherbetrieb, einem Betrieb als serielles Schieberegister, einem Testkomprimierungsbetrieb und einen Initialisierungsbetrieb umschaltbar ist.

11. Schaltungszelle nach Anspruch 6,
**dadurch gekennzeichnet,**
**daß** die kombinatorische Schaltung (3) aus Signalleitungen besteht.

## Claims

1. Method for testing circuit cells (1) in an integrated circuit, a circuit cell (1) containing a deductive circuit (3) for data processing, a memory unit (2) and a memory control unit (4) in each case, the circuit cells (1), the test pattern generation and the test pattern evaluation being synchronized in decentralized fashion by the memory control units (4) contained in the circuit cells (1), and the method having the following steps:
(a) One circuit cell is initialized (S1) as a test pattern transmission circuit cell and one circuit cell is initialized (S1) as a test pattern reception circuit cell;
(b) An instruction signal is transmitted (S2) from the memory control unit (4) in the test pattern transmission circuit cell to the associated memory unit (2) in order to generate a test pattern;
(c) The generated test pattern is applied (S3) to the deductive circuit (3) for data processing by the memory unit in the test pattern transmission circuit cell;
(d) A request signal (R) is transmitted (S4) by the memory control unit (4) in the test pattern transmission circuit cell to the memory control unit (4) in the test pattern reception circuit cell;
(e) An instruction for test pattern compression is transmitted (S5) to the memory unit (2) in the
(f) An acknowledgement signal (A) is transmitted (S6) from the memory control unit (4) in the test pattern reception circuit cell to the memory control unit in the test pattern transmission circuit cell;
(g) The memory unit (2) in the test pattern reception circuit cell is switched to a test data evaluation mode by the memory control unit (4) in the test pattern reception circuit cell;
(h) A request signal is transmitted (S10) to the test machine (19) in order for the compressed test data to be read out by the memory control unit (4) in the test pattern reception circuit cell;
(i) The test data is read out of the memory unit (2) in the test pattern reception circuit cell by the test machine (19).

2. Method according to Claim 1,
**characterized**
**in that** the test data read out is compared with a nominal response for the test data.

3. Method according to one of the preceding claims,
**characterized**
**in that** the memory unit (2) in the circuit cell is synchronized by a synchronizing signal which is generated by the associated memory control unit (4) on the basis of communication signals which are interchanged by the memory control unit (4) and memory control units in further standard cells.

4. Method according to one of the preceding claims,
**characterized**
**in that** the memory control units (4) in the various circuit cells interchange data transmission request signals and data reception acknowledgement signals amongst one another as communication signals.

5. Method according to one of the preceding claims,
**characterized**
**in that** the decentralized synchronization takes place using handshake signals.

6. Circuit cell in an integrated circuit having a built-in self-test function for a circuit of modular design, having:
(a) a memory unit (2) for storing data;
(b) a deductive circuit (3) for data processing;
(c) a memory control unit (4) for controlling the memory unit (2),
**Characterized in that** the memory control unit (4) is configurable such that it sets the memory unit (2) as a test pattern generator in a transmission mode and sets it as a test pattern compression device in a reception mode, and the memory control unit (4) generates a synchronizing signal for synchronizing the memory unit (2) on the basis of communication signals which are interchanged by the memory control unit (4) and memory control units in further circuit cells in the integrated circuit.

7. Circuit cell according to Claim 6,
**characterized**
**in that** the memory control unit (4) can be connected to memory control units in further circuit cells (1) via at least two communication line pairs (13, 14; 15, 16), each communication line pair having a data transmission request line (13, 15) and a data reception acknowledgement line (14, 16).

8. Circuit cell according to one of the preceding claims,
**characterized**
**in that** the memory control unit (4) can be connected to at least one test machine (19) via a communication line pair (17, 18), the test machine (19) being able to use decentralized synchronizing signals to initialize the memory control unit (4) via an initialization line (17), and the memory control unit (4) transmitting internal state data to the test machine (19) via a state reporting line (18).

9. Circuit cell according to one of the preceding claims,
**characterized**
**in that** the memory unit (2) is a register which can be switched between the various modes of operation.

10. Circuit cell according to Claim 9,
**characterized**
**in that** the register can be changed over between a normal data storage mode, a mode as a serial shift register, a test compression mode and an initialization mode.

11. Circuit cell according to Claim 6,
**characterized**
**in that** the deductive circuit (3) comprises signal lines.

## Revendications

1. Procédé de test de cellules de circuit (1) d'un circuit intégré, une cellule de circuit (1) contenant à chaque fois un circuit combinatoire (3) pour le traitement de données, une unité mémoire (2) et une unité de commande de mémoire (4), la synchronisation entre les cellules de circuit (1), la génération d'échantillons de test et l'évaluation d'échantillons de test s'effectuant de- manière décentralisée au moyen des unités de commande de mémoire (4) contenues dans les cellules de circuit (1) et le procédé comportant les étapes suivantes :
(a) initialiser (S1) une cellule de circuit comme cellule de circuit d'émission d'échantillon de test et une cellule de circuit comme cellule de circuit de réception d'échantillon de test ;
(b) émettre (S2) un signal d'instruction par l'unité de commande de mémoire (4) de la cellule de circuit d'émission d'échantillon de test vers l'unité mémoire associée (2) en vue de la génération d'un échantillon de test ;
(c) appliquer (S3) l'échantillon de test généré au circuit combinatoire (3) par l'unité mémoire de la cellule de circuit d'émission d'échantillon de test pour le traitement de données ;
(d) émettre (S4) un signal de demande (R) par l'unité de commande de mémoire (4) de la cellule de circuit d'émission d'échantillon de test vers l'unité de commande de mémoire (4) de la cellule de circuit de réception d'échantillon de test ;
(e) émettre (S5) une instruction par l'unité de commande de mémoire (4) de la cellule de circuit de réception d'échantillon de test vers l'unité mémoire (2) de la cellule de circuit de réception d'échantillon de test pour la compression d'échantillon de test ;
(f) émettre (S6) un signal de confirmation (A) par l'unité de commande de mémoire (4) de la cellule de circuit de réception d'échantillon de test vers l'unité de commande de mémoire de la cellule de circuit d'émission d'échantillon de test ;
(g) commuter l'unité mémoire (2) de la cellule de circuit de réception d'échantillon de test dans un mode d'évaluation de données de test par l'unité de commande de mémoire (4) de la cellule de circuit de réception d'échantillon de test ;
(h) émettre (S10) un signal de demande par l'unité de commande de mémoire (4) de la cellule de circuit de réception d'échantillon de test vers l'automate de test (19) pour la lecture des données de test comprimées ;
(i) lire les données de test par l'automate de test (19) dans l'unité mémoire (2) de la cellule de circuit de réception d'échantillon de test.

2. Procédé selon la revendication 1,
**caractérisé en ce que** les données de test lues sont comparées à une réponse de consigne de données de test.

3. Procédé selon l'une des revendications précédentes,
**caractérisé en ce que** l'unité mémoire (2) de la cellule de circuit est synchronisée au moyen d'un signal de synchronisation qui est produit par l'unité de commande de mémoire associée (4) en fonction de signaux de communication que l'unité de commande de mémoire (4) échange avec des unités de commande de mémoire d'autres cellules standards.

4. Procédé selon l'une des revendications précédentes,
**caractérisé en ce que** les unités de commande de mémoire (4) des différentes cellules de circuit échangent entre elles, comme signaux de communication, des signaux de demande d'émission de données et des signaux de confirmation de réception de données.

5. Procédé selon l'une des revendications précédentes,
**caractérisé en ce que** la synchronisation décentralisée s'effectue par l'intermédiaire de signaux de prise de contact Handshake.

6. Cellule de circuit dans un circuit intégré avec fonction d'autotest intégrée pour un circuit à structure modulaire, avec :
(a) une unité mémoire (2) pour la mémorisation de données ;
(b) un circuit combinatoire (3) pour le traitement de données ;
(c) une unité de commande de mémoire (4) pour la commande de l'unité mémoire (2) ;
**caractérisée en ce que**
l'unité de commande de mémoire (4) est configurable de telle sorte que, dans un mode d'émission, elle règle l'unité mémoire (2) comme générateur d'échantillon de test et, dans un mode de réception, elle la règle comme dispositif de compression d'échantillon de test, et
l'unité de commande de mémoire (4) produit un signal de synchronisation pour la synchronisation de l'unité mémoire (2) en fonction de signaux de communication que l'unité de commande de mémoire (4) échange avec des unités de commande de mémoire d'autres cellules de circuit du circuit intégré.

7. Cellule de circuit selon la revendication 6,
**caractérisée en ce que** l'unité de commande de mémoire (4) est raccordable par l'intermédiaire d'au moins deux paires de lignes de communication (13, 14 ; 15, 16) à des unités de commande de mémoire d'autres cellules de circuit (1), chaque paire de lignes de communication comportant une ligne de demande d'émission de données (13, 15) et une ligne de confirmation de réception de données (14, 16).

8. Cellule de circuit selon l'une des revendications précédentes,
**caractérisée en ce que** l'unité de commande de mémoire (4) est raccordable par l'intermédiaire d'une paire de lignes de communication (17, 18) à au moins un automate de test (19), l'unité de commande de mémoire (4) pouvant être initialisée par l'automate de test (19) par l'intermédiaire d'une ligne d'initialisation (17) à l'aide de signaux de synchronisation décentralisés et l'unité de commande de mémoire (4) émettant des données d'état interne vers l'automate de test (19) par l'intermédiaire d'une ligne de signalisation d'état (18).

9. Cellule de circuit selon l'une des revendications précédentes,
**caractérisée en ce que** l'unité mémoire (2) est un registre qui est commutable entre les différents modes d'exploitation.

10. Cellule de circuit selon la revendication 9,
**caractérisée en ce que** le registre est commutable entre une exploitation normale comme mémoire de données, une exploitation comme registre à décalage sériel, une exploitation de compression de test et une exploitation d'initialisation.

11. Cellule de circuit selon la revendication 6,
**caractérisée en ce que** le circuit combinatoire (3) est constitué de lignes de signaux.
